# EUROPEAN PATENT SPECIFICATION

(11) **EP 2 353 349 B1**
(45) Date of publication and mention of the grant of the patent: **17.04.2013**
(21) Application number: 08876276.0
(22) Date of filing: 03.11.2008
(51) Int. Cl.: H05K 7/20

(54) **HEATER CONTROL IN A RADIO NETWORK NODE**
HEIZUNGSSTEUERUNG IN EINEM FUNKNETZKNOTEN
COMMANDE DE CHAUFFAGE DANS UN NOEUD DE RESEAU RADIO

(43) Date of publication of application: 10.08.2011
(73) Proprietor: Telefonaktiebolaget L M Ericsson (publ), 164 83 Stockholm (SE)
(72) Inventor: HEDBERG, Klas, S-141 38 Huddinge (SE); JONSSON, Fredrik, S-197 34 Bro (SE)
(74) Representative: Kühn, Friedrich Heinrich
(86) International application number: PCT/SE2008/051251
(87) International publication number: WO 2010/050865

(56) References cited:
- EP-A1- 1 906 720
- WO-A2-2006/058342
- US-A- 6 104 003

## Description

### TECHNICAL FIELD

The present invention relates to an arrangement and a method in a radio network node for controlling the temperature in the arrangement and more particular, to an arrangement and method for heater control.

### BACKGROUND

Generally, a radio communication system of today comprises a radio access network and a number of communication devices. The radio access network is built up of several radio network nodes, in particular, radio base stations. The primary task of a radio base station is to send and receive information to/from the communication devices within a cell served by the radio base station. In many cases, the base station is run 24 hours a day. Therefore, it is of particular interest and importance to ensure that the base station is operable predictably and reliably. The radio base station further comprises a cabinet, which comprises an enclosure for housing circuitry, or electronic equipment, for performing different tasks of the radio base station. For example, the circuitry may comprise a power control unit, a radio unit comprising a radio amplifier, and a filtering unit for performing corresponding tasks.

Due to low efficiency of the radio amplifier of the radio base station, heat generated in the circuitry of the base station, in particular the radio unit, may not always dissipate naturally to a sufficiently high degree. Instead, heat is accumulated in the circuitry and temperature of the circuitry increases. The increased temperature of the circuitry may decrease the performance of circuitry within the radio base station, e.g. the circuitry within the radio base station may fail. Hence, as is known in the art, systems for cooling of heat generating equipment within a radio base station have been developed. These systems are sometimes referred to as climate systems or climate control systems for radio base stations.

Externally mounted enclosures for mobile radio base stations potentially experience a wide range of ambient temperatures. At low external ambient temperatures, the heating which arises naturally from the electronic equipment is sometimes insufficient to keep the internal temperature sufficiently high. A heater is therefore desired for warming up the air within the enclosure. Further, in a cold start situation in which the internal temperature in the radio base station is below that at which the electronic equipment is operative, a heater is needed to warm up the equipment before starting up the system.

In the prior art, for example in EP 1 906 720, it is known to use resistor heaters, for example a metal tube heater or a Positive Temperature Coefficient - heater (PTC - heater) for warming up an enclosure comprising electronic equipment within a radio base station. These two types of resistor heaters have slightly different working modes. The temperature of a metal tube heater depends on the temperature of the cooling media temperature, the cooling media flow and the electrical voltage. A higher cooling media temperature, a reduced media flow and a higher electrical voltage give a higher heater temperature. For a PTC-heater, the heat generation of the heater depends on the temperature of the PTC-heater, whereby the higher the temperature the lower the heat generation. This means that the heat generation is dependent on the cooling media temperature and the cooling media flow.

Normally, a heater used for warming up the air within the cabinet is located in the passage of the media flow for the whole cabinet, i.e. a system media flow. A resistor heater with a high cooling fin density causes a high pressure drop. Consequently, the total system pressure drop will increase and hence the required power consumption for the temperature regulating media flow generation will also increase as the heater is positioned where the system media flow has to pass. If just a part of the media flow is made to pass through the heater, this flow will be very limited because of the pressure drop over the heater, and thus results in a low heat generation for a PTC-heater or a high heater temperature for a metal tube heater.

This problem can be solved by adding a separate fan for the heater. However, the added fan occupies precious space in the radio base station and decreases reliability of the system as there is always a risk for fan failure. Further, a separate fan also adds on extra costs. To avoid the high pressure drop, metal tube heaters without fins are sometimes used. However, when the heater temperature rises it results in a high heat radiation from the heater affecting the electrical equipment or other objects near to the heater.

### SUMMARY

It is an object of the present invention to provide an arrangement and a method in a radio network node with improved heater control.

According to a first aspect of the invention, the object is achieved by an arrangement for controlling a heater in a radio network node. The arrangement comprises a heater for warming air in the arrangement and at least a first flow generating device and a second flow generating device for generating a general air flow within the arrangement. The heater is arranged in between the first flow generating device and the second flow generating device whereby the air flowing through the heater becomes dependent on the setting of the first and second flow generating devices.

According to a second aspect of the invention, the object is achieved by a method for controlling a heater in radio network node arrangement. The arrangement comprises a heater and at least a first flow generating device and a second flow generating device for generating a general air flow in the arrangement. The first flow generating device generates a first fluid flow to one side of the heater and the second flow generating device generates a second fluid flow to the opposite side of the heater. By regulating the first and second flow generating devices, a fluid flow through the heater occurs which is dependent on the setting of the first and second flow generating devices.

An advantage with the present invention is that the system pressure drop is minimised due to the position of the heater in between the flow generating devices whereby the heater is not disturbing the general temperature regulating media flow. Further, there is no need for a separate heater fan and, thus both space and costs are saved by the arrangement and method according the invention. Hence, an improved arrangement and method for heater control in a radio network node is provided in accordance with the object of the invention.

### BRIEF DESCRIPTION OF THE DRAWINGS

The various aspects of the invention, including its particular features and advantages, will be readily understood from the following detailed description and the accompanying drawings, in which
**Figure 1** illustrates a side view of a schematic radio network node comprising the arrangement according to the present invention,
**Figures 2a** and **2b** show a schematic front view of a part of the arrangement according some embodiments, and
**Figure 3** is a flow chart showing a method in a radio network node.

### DETAILED DESCRIPTION

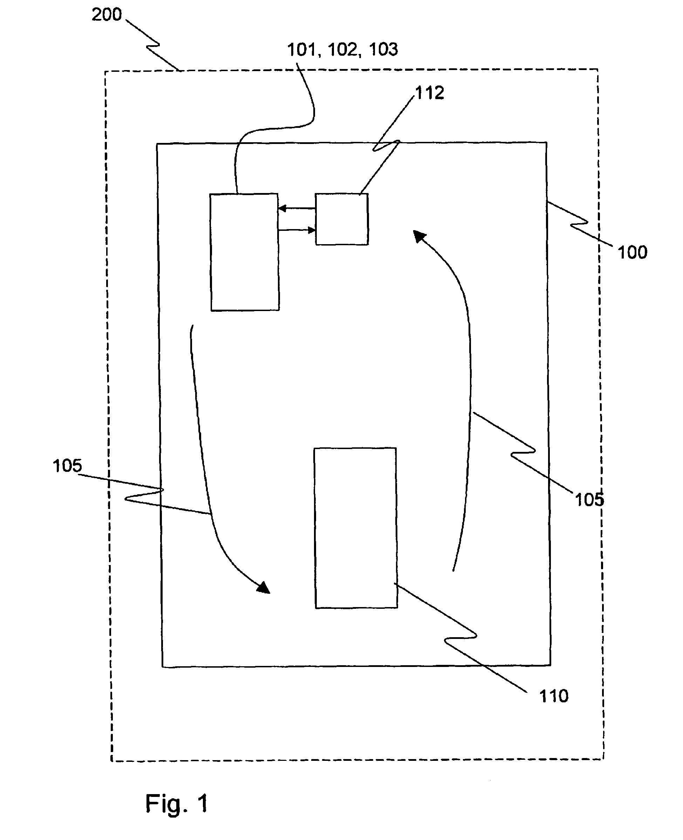

**Figure 1** shows a side view of a schematic arrangement 100 comprised in a radio network node 200. The arrangement 100 comprises a heater 101 for warming air within the arrangement, if necessary. The arrangement 100 further comprises at least two flow generating devices 102, 103 for generating a general air flow 105 within the arrangement 100 for regulating the temperature of electronic equipment 110 housed within the arrangement. The at least two flow generating devices 102, 103 may be for example fans. The heater 101 is positioned in between the first flow generating device 102 and the second flow generating device 103. When the first and second flow generating devices 102, 103 are set to generate a general air flow 105 within the arrangement 100, the amount of air flowing through the heater 101 becomes dependent on the setting of the first and second flow generating devices. The arrangement also comprises a controller 112 for controlling the first and second flow generating devices 102, 103.

As **Figure 1** is a side view of the arrangement 100 in which the heater 101 and the first and second flow generating devices 102, 103 cannot be seen separately. Instead, the box with reference numbers 101, 102, 103 represents all three items being the heater 101 and the first and second flow generating devices 102, 103. Further, it is to be understood that the arrangement shown in **Figure 1** is simplified and hence does not show all the parts of a radio network node. For example, the arrangement according to **Figure 1** may also comprise one or more heat exchangers for cooling of electronic equipment, enclosures for housing the equipment and further flow generating devices.

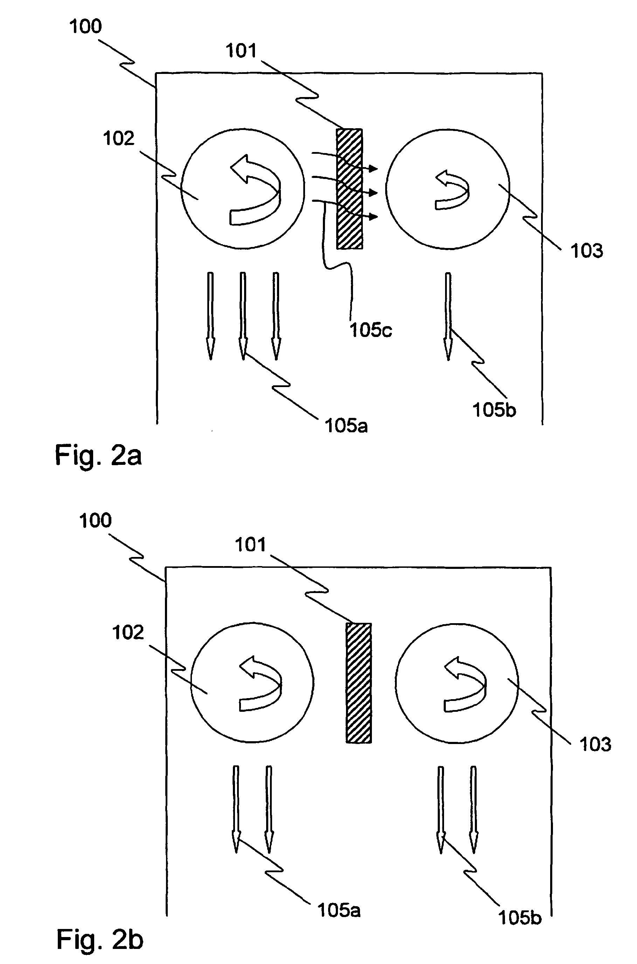

**Figure 2a** and **2b** show a more detailed front view of a part of the arrangement 100 according to the invention. The heater 101 is positioned in between to the first and second flow generating devices 102, 103. **Figure 2a** shows the arrangement 100 in a heating mode which means that the heater 101 is set to warm air within the arrangement 100.

**Figure 2b** shows the arrangement 100 in a non-heating mode, thus the heater 101 is turned off and the first and second flow generating devices 102, 103 generate a general air flow 105 for cooling purposes.

In **Figure 2a****,** the first flow generating device 102 generates a first air flow 105a at one side of the heater 101. This is illustrated by three arrows and the air flow 105a provides a first portion to the general air flow 105 within the arrangement 100. The second flow generating device 103 generates a second air flow 105b at the other side of the heater 101. This is illustrated by a single arrow and the air flow 105b provides a second portion to the general air flow 105 within the arrangement. The difference in flow velocity between the first and second air flow 105a, 105b, is illustrated by the number of the arrows. Thus, the flow velocity of the first portion 105a of the general air flow 105 is greater than the flow velocity of the second portion 105b of the general air flow 105. The heater 101 is positioned in between the first and second flow generating devices 102, 103. The difference in flow velocity on the respective sides of the heater 101 generates a difference in pressure build-up on the two sides of the heater 101, which generates an air flow 105c through the heater 101.

The size of the fluid flow 105c through the heater 101 is determined by the regulation of the first and second flow generating devices 102, 103. The higher difference in flow velocity between the first and second air flow 105a, 105b, the more air 105c passes through the heater 101. It is to be understood that it may also be the other way round, such that the second flow generating device 103 generates a higher air flow velocity than the first flow generating device 102.

By controlling the first flow generating device 102 or the second flow generating device 103 or both the first and second regulating devices 102, 103, i.e. at least one of the first and second flow generating devices 102, 103, the heater 101 temperature or heat generation of the heater 101 can be regulated. The temperature of the heater 101 or heat generation of the heater 101 is regulated without addition of any new parts or components. For example, no specific heater fan is needed. Further, the heater 101 is mounted in a way that no adding to the system pressure drop is made. The heater 101 used in this arrangement 100 may be any kind of resistor heater, such as a metal tube heater or a Positive Temperature Coefficient - heater (PTC-heater), for example. The described arrangement 100 as illustrated in **Figure 2a** makes it possible to generate high heat output in a limited space without disturbing the general air flow 105 in for example a radio network node.

In **Figure 2b** the first flow generating device 102 generates a first air flow 105a at one side of the heater 101. This is illustrated by two arrows and the air flow 105a provides a first portion to the general air flow 105 within the arrangement. The second flow generating device 103 generates a second air flow 105b at the other side of the heater 101. This is illustrated by two arrows and the air flow 105b provides a second portion to the general air flow 105 within the arrangement 100. In this case, there is no difference in flow velocity between the first and second air flow 105a, 105b and no pressure build-up will take place and consequently no air flow occurs through the heater 101. By its position in between the first and second flow generating devices 102, 103 the heater does not disturb the general air flow 105 when it is not used.

The general air flow 105 comprises the first air flow 105a, the second air flow 105b and the air flow through the heater 105c, if any.

It is to be understood that the radio network node may be a Radio Base Station (RBS) or any other kind of node in a radio communication system, which radio network node comprises heat generating electronic equipment. Examples of other kinds of nodes are transmission nodes, Remote Subscriber Switches (RSS) and nodes with similar functionality.

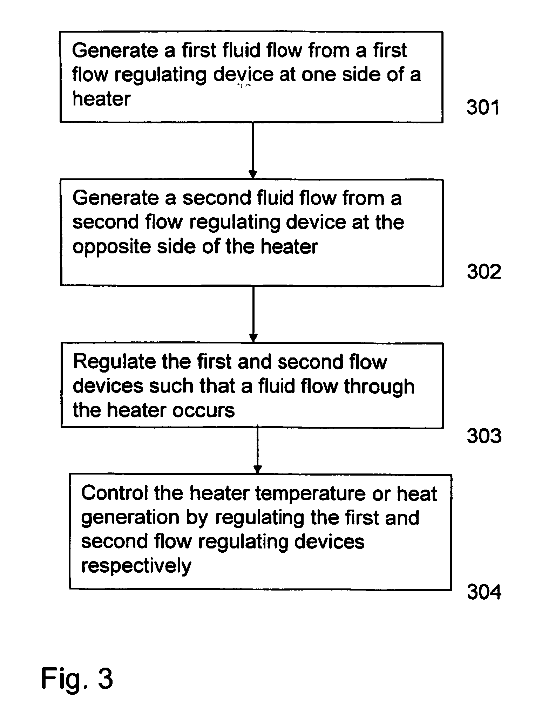

The method steps in the radio network node 200 for controlling a heater 101 in a radio network node arrangement 100 will now be described with reference to a flow chart depicted in **Figure 3****.** As mentioned above, the arrangement 100 comprises a heater 101 and at least a first flow generating device 102 and a second flow generating device 103 for generating a general air flow 105 in the arrangement.
301. The first flow generating device 102 generates a first air flow 105a at one side of the heater 101.
302. The second flow generating device 103 generates a second air flow 105b at the opposite side of the heater 101.
303. By regulating the first and second flow generating devices 102, 103, an air flow 105c through the heater 101 occurs which is dependent on the setting of the first and second flow generating devices 102, 103.
304. This step is optional. According to an embodiment of the invention the heater temperature or heat generation of the heater 101 is controlled by regulating the first flow generating device 102 and the second flow generating device 103 respectively. The control of the heater temperature or heat generation of the heater 101 is based on a difference in flow velocity of the first air flow 105a and the flow velocity of the second air flow 105b.

When using the word "comprise" or "comprising" it shall be interpreted as non-limiting, in the meaning of "consist at least of".

## Claims

1. An arrangement (100) for controlling a heater in a radio network node (200), the arrangement comprising
- the heater (101) for warming air in the arrangement (100),
- a first flow generating device (102) and a second flow generating device (103) for generating a general air flow (105) within the arrangement (100), the heater (101) is arranged in between the first flow generating device (102) and the second flow generating device (103) whereby the air flowing through the heater (105c) becomes dependent on the setting of the first and second flow generating devices (102, 103), the arrangement (100) further comprises a controller (112) for controlling the first and second flow generating devices (102, 103), wherein the control of the heater (101) temperature or the heat generation of the heater (101) is based on a difference in fluid flow velocity of the first fluid flow (105a) generated by the first flow generating device (102) and the velocity of the second fluid flow (105b) generated by the second flow generating device (103).

2. Arrangement according claim 1, wherein the heater (101) is a Positive Temperature Coefficient - heater.

3. Arrangement according to claim 1, wherein the heater (101) is a metal tube heater.

4. Arrangement according to any one of the preceding claims, wherein the radio network node (200) is a radio base station.

5. A method in a radio network node arrangement (100) for controlling a heater (101), the arrangement (100) comprising the heater (101) and a first flow generating device (102) and a second flow generating device (103) for generating a general air flow (105) in the arrangement (100), the method comprising the steps of:
- *generating* a first fluid flow (105a) from the first flow generating device (102) at one side of the heater (101),
- *generating* a second fluid flow (105b) from the second flow generating device (103) at the opposite side of the heater (101),
- *regulating* the first and second flow generating devices (102, 103) such that an air flow (105c) through the heater (101) occurs which air flow (105c) is dependent on the setting of the first and second flow generating devices (102, 103), and
- *controlling* the heater (101) temperature or the heat generation of the heater (101) by regulating the first flow generating device (102) and the second flow generating device (103) respectively based on a difference in fluid flow velocity of the first fluid flow (105a) and the velocity of the second fluid flow (105b).

## Patentansprüche

1. Anordnung (100) zum Steuern einer Heizung in einem Funknetzknoten (200), wobei die Anordnung umfasst:
- die Heizung (101) zum Erwärmen von Luft in der Anordnung (100),
- eine erste Luftstromerzeugungsvorrichtung (102) und eine zweite Luftstromerzeugungsvorrichtung (103) zum Erzeugen eines allgemeinen Luftstroms (105) innerhalb der Anordnung (100), wobei die Heizung (101) zwischen der ersten Luftstromerzeugungsvorrichtung (102) und der zweiten Luftstromerzeugungsvorrichtung (103) angeordnet ist, wodurch Luft, die durch die Heizung strömt (105c), von der Einstellung der ersten und zweiten Luftstromerzeugungsvorrichtungen (102, 103) abhängig wird, wobei die Anordnung (100) ferner eine Steuerung (112) zum Steuern der ersten und zweiten Luftstromerzeugungsvorrichtungen (102, 103) umfasst, wobei die Steuerung der Temperatur der Heizung (101) oder der Wärmeerzeugung der Heizung (101) auf einer Differenz der Fluidströmungsgeschwindigkeit des ersten Fuidstroms (105a), der durch die erste Luftstromerzeugungsvorrichtung (102) erzeugt wird, und der Geschwindigkeit des zweiten Fluidstroms (105b) basiert, der durch die zweite Luftstromerzeugungsvorrichtung (103) erzeugt wird.

2. Anordnung nach Anspruch 1, wobei die Heizung (101) eine Heizung mit positivem Temperaturkoeffizienten ist.

3. Anordnung nach Anspruch 1, wobei die Heizung (101) eine Metallrohrheizung ist.

4. Anordnung nach einem der vorhergehenden Ansprüche, wobei der Funknetzknoten (200) eine Funkbasisstation ist

5. Verfahren in einer Funknetzknotenanordnung (100) zur Steuerung einer Heizung (101), wobei die Anordnung (100) die Heizung (101) und eine erste Luftstromerzeugungsvorrichtung (102) und eine zweite Luftstromerzeugungsvorrichtung (103) zum Erzeugen eines allgemeinen Luftstroms (105) in der Anordnung (100) umfasst, wobei das Verfahren die folgenden Schritte umfasst:
- Erzeugen eines ersten Fluidstroms (105a) aus der ersten Luftstromerzeugungsvorrichtung (102) an einer Seite der Heizung (101),
- Erzeugen eines zweiten Fluidstroms (105b) aus der zweiten Luftstromerzeugungsvorrichtung (103) an der gegenüberliegenden Seite der Heizung (101),
- derartiges Regulieren der ersten und zweiten Luftstromerzeugungsvorrichtungen (102, 103), dass ein Luftstrom (105c) durch die Heizung (101) entsteht, wobei der Luftstrom (105c) von der Einstellung der ersten und zweiten Luftstromerzeugungsvorrichtungen (102, 103) abhängt, und
- Steuern der Temperatur der Heizung (101) oder der Wärmeerzeugung der Heizung (101) durch Regulieren der ersten Luftstromerzeugungsvorrichtung (102) und der zweiten Luftstromerzeugungsvorrichtung (103) jeweils basierend auf einer Differenz der Fluidströmungsgeschwindigkeit des ersten Fluidstroms (105a) und der Geschwindigkeit des zweiten Fluidstroms (105b).

## Revendications

1. Dispositif (100) de commande d'un chauffage dans un noeud de réseau radio (200), le dispositif comprenant :
- le chauffage (101) pour réchauffer l'air dans le dispositif (100),
- un premier dispositif de génération de flux (102) et un second dispositif de génération de flux (103) pour générer un flux d'air général (105) à l'intérieur du dispositif (100), le chauffage (101) est agencé entre le premier dispositif de génération de flux (102) et le second dispositif de génération de flux (103), moyennant quoi l'air circulant à travers le chauffage (105c) dépend du paramétrage du premier et du second dispositifs de génération de flux (102,103), le dispositif (100) comprend en outre un contrôleur (112) pour commander le premier et le second dispositifs de génération de flux (102,103), dans lequel la commande de la température du chauffage (101) ou de la génération de chaleur du chauffage (101) est basée sur une différence de vitesse du premier flux de fluide (105a) généré par le premier dispositif de génération de fluide (102) et de vitesse du second flux de fluide (105b) généré par le second dispositif de génération de flux (103).

2. Dispositif selon la revendication 1, dans lequel le chauffage (101) est un chauffage à coefficient de température positif.

3. Dispositif selon la revendication 1, dans lequel le chauffage (101) est un chauffage à tubes métalliques.

4. Dispositif selon une quelconque des revendications précédentes, dans lequel le noeud de réseau radio (200) est une station radio de base.

5. Procédé dans un dispositif de noeud de réseau radio (100) de commande d'un chauffage (101), le dispositif (100) comprenant le chauffage (101) et un premier dispositif de génération de flux (102) et un second dispositif de génération de flux (103) pour générer un flux d'air général (105) dans le dispositif (100), le procédé comprenant les étapes consistant à :
- générer un premier flux de fluide (105a) à partir du premier dispositif de génération de flux (102) sur un côté du chauffage (101),
- générer un second flux de fluide (105b) à partir du second dispositif de génération de flux (103) sur le côté opposé du chauffage (101),
- réguler le premier et le second dispositif de génération de flux (102,103) de sorte qu'un flux d'air (105c) à travers le chauffage (101) se produise, lequel flux d'air (105c) dépend du paramétrage du premier et du second dispositifs de génération de flux (102,103), et
- commander la température du chauffage (101) ou de la génération de chaleur du chauffage (101) en régulant le premier dispositif de génération de flux (102) et le second dispositif de génération de flux (103) respectivement sur la base d'une différence de vitesse de flux de fluide du premier flux de fluide (105a) et de vitesse du second flux de fluide (105b).
